# EUROPEAN PATENT SPECIFICATION

(11) **EP 4 429 427 B1**
(45) Date of publication and mention of the grant of the patent: **27.08.2025**
(21) Application number: 23305321.4
(22) Date of filing: 09.03.2023
(51) Int. Cl.: H05K 7/20

(54) **BAFFLING ASSEMBLY FOR MITIGATING MOVEMENT OF A HEATTRANSFER LIQUID IN AN IMMERSION CASE**
ABLENKEINHEIT ZUR BEWEGUNGSMINDERUNG EINER WÄRMEÜBERTRAGUNGSFLÜSSIGKEIT IN EINEM TAUCHGEHÄUSE
ENSEMBLE DÉFLECTEUR POUR ATTÉNUER LE MOUVEMENT D'UN LIQUIDE DE TRANSFERT DE CHALEUR DANS UN BOÎTIER D'IMMERSION

(43) Date of publication of application: 11.09.2024
(73) Proprietor: OVH, 59100 Roubaix (FR)
(72) Inventor: CHEHADE, Ali, 59283 Moncheaux (FR); HNAYNO, Mohamad, 59100 Roubaix (FR); MASRI, Charbel, 59000 Lille (FR)
(74) Representative: BCF Global

(56) References cited:
- WO-A1-2021/212425
- US-A1- 2021 206 567

## Description

### FIELD

The present technology relates generally to cooling technologies, and more specifically to baffling assemblies for mitigating movement of a heat-transfer liquid in an immersion case.

### BACKGROUND

Electronic equipment, for example servers, memory banks, computer discs, and the like, is conventionally grouped in equipment racks. Large data centers and other large computing facilities may contain thousands of racks supporting thousands or even tens of thousands of servers.

The racks, including equipment mounted in their backplanes, consume large amounts of electric power and generate significant amounts of heat. Cooling needs are important in such racks. Some electronic devices, such as processors, generate so much heat that they could fail within seconds in case of a lack of cooling.

Immersion cooling (sometimes called immersive cooling) of equipment racks was recently introduced. Electronic components are inserted in an immersion case that is fully or partially filled with a heat-transfer liquid (sometimes called a non-conducting cooling liquid), for example an oil-based dielectric cooling liquid. Good thermal contact is obtained between the electronic components and the heat-transfer liquid. The immersion case may be open-ended on at least one side (e.g. a top side), and is generally filled with the heat-transfer liquid until the electronic components are completely submerged in the heat-transfer liquid.

Technicians or other personnel frequently need to rack equipment in and out, in order to replace defective components or perform other routine maintenance tasks requiring access to the electronic equipment. The act of racking equipment may cause motion of the heat-transfer liquid within the immersion case, leading to overflowing of the heat-transfer liquid and spillage outside of the immersion case. The loss of heat-transfer liquid may lead to the electronic equipment within the immersion case being inadequately covered by the remaining 301931308.1 heat-transfer liquid and therefore degrading the overall heat transfer capability of the equipment rack. The spilled heat-transfer liquid also creates a safety hazard and needs to be cleaned, creating an additional maintenance burden for facility personnel. Facility operators may also face a substantial cost of replacing spilled heat-transfer liquid.

US Pat. Pub. No. US 2021/0206567 to Lau discloses an immersion cooling system for cooling an object in an immersion cooling tank that includes an anti-sloshing device adapted to be attached/attachable to an inner surface of the immersion cooling tank. The anti-sloshing device includes a connecting device(s), a first plate fixedly attached to or rotatably attached to the connecting device, and a second plate rotatably attached to the connecting device.

WO 2021/212425 Al to Lan discloses a server tank, comprising an tank body and a cover plate and a movable covering part. The tank body comprises a chamber that is enclosed by a bottom wall and side walls of the tank body with an opening that is opposite to the bottom wall. The chamber is configured to be capable of accommodating computer servers and containing a liquid serving as an immersion cooling medium for the servers. The cover plate openably covers the opening of the chamber in which the covering part is adjustable.

There is thus a desire to mitigate at least some of the aforementioned drawbacks.

The subject matter discussed in the background section should not be assumed to be prior art merely as a result of its mention in the background section. Similarly, a problem mentioned in the background section or associated with the subject matter of the background section should not be assumed to have been previously recognized in the prior art. The subject matter in the background section merely represents different approaches.

### SUMMARY

Embodiments of the present technology have been developed based on developers' appreciation of shortcomings associated with the prior art.

In particular, such shortcomings may comprise (1) overflowing of heat-transfer liquid when racking in or out electronic equipment; and/or (2) minimizing cleaning of spilled heat-transfer liquid.

The invention associated with the present technology is defined as in appended claim 1. Preferred embodiments of the invention are presented in dependent claims 2-11.

Implementations of the present technology each have at least one of the above-mentioned object and/or aspects, but do not necessarily have all of them. It should be understood that some aspects of the present technology that have resulted from attempting to attain the above-mentioned object may not satisfy this object and/or may satisfy other objects not specifically recited herein.

Additional and/or alternative features, aspects and advantages of implementations of the present technology will become apparent from the following description, the accompanying drawings and the appended claims.

### BRIEF DESCRIPTION OF THE DRAWINGS

For a better understanding of the present technology, as well as other aspects and further features thereof, reference is made to the following description which is to be used in conjunction with the accompanying drawings, where:
Figure 1 is a schematic diagram of an immersion cooling system in accordance with a non-limiting implementation of the present technology;
Figure 2 shows a perspective view of the cooling system of Figure 1 in accordance with another non-limiting implementation of the present technology;
Figure 3A shows a perspective view of the cooling system of Figure 2 with a baffling assembly including a first baffle element and a second baffle element, in accordance with yet another non-limiting implementation of the present technology;
Figure 3B shows a top elevation view of the cooling system of Figure 3A;
Figure 4A shows a perspective view of the cooling system of Figure 2 with a baffling assembly including a plurality of baffle elements, in accordance with yet another non-limiting implementation of the present technology;
Figure 4B shows a front elevation view of one of the plurality of baffle elements of Figure 4A, in accordance with yet another non-limiting implementation of the present technology;
Figure 5A shows a perspective view of the cooling system of Figure 2 with a baffling assembly including a plurality of baffle elements, in accordance with yet another non-limiting implementation of the present technology; and
Figure 5B shows a front elevation view of one of the plurality of baffle elements of Figure 5A, in accordance with yet another non-limiting implementation of the present technology.

It should also be noted that, unless otherwise explicitly specified herein, the drawings are not to scale.

### DETAILED DESCRIPTION

The examples and conditional language recited herein are principally intended to aid the reader in understanding the principles of the present technology and not to limit its scope to such specifically recited examples and conditions. It will be appreciated that those skilled in the art may devise various arrangements that, although not explicitly described or shown herein, nonetheless embody the principles of the present technology.

Furthermore, as an aid to understanding, the following description may describe relatively simplified implementations of the present technology. As persons skilled in the art would understand, various implementations of the present technology may be of a greater complexity.

In some cases, what are believed to be helpful examples of modifications to the present technology may also be set forth. This is done merely as an aid to understanding, and, again, not to define the scope or set forth the bounds of the present technology. These modifications are not an exhaustive list, and a person skilled in the art may make other modifications while nonetheless remaining within the scope of the present technology. Further, where no examples of modifications have been set forth, it should not be interpreted that no modifications are possible and/or that what is described is the sole manner of implementing that element of the present technology.

Moreover, all statements herein reciting principles, aspects, and implementations of the present technology, as well as specific examples thereof, are intended to encompass both structural and functional equivalents thereof, whether they are currently known or developed in the future. Thus, for example, it will be appreciated by those skilled in the art that any block diagrams herein represent conceptual views of illustrative systems embodying the principles of the present technology.

In the context of the present specification, unless expressly provided otherwise, a computer system may refer, but is not limited to, an "electronic device", an "operation system", a "system", a "computer-based system", a "controller unit", a "monitoring device", a "control device" and/or any combination thereof appropriate to the relevant task at hand.

In the context of the present specification, unless expressly provided otherwise, the words "first", "second", "third", etc. have been used as adjectives only for the purpose of allowing for distinction between the nouns that they modify from one another, and not for the purpose of describing any particular relationship between those nouns.

With these fundamentals in place, we will now consider some non-limiting examples to illustrate various implementations of aspects of the present technology.

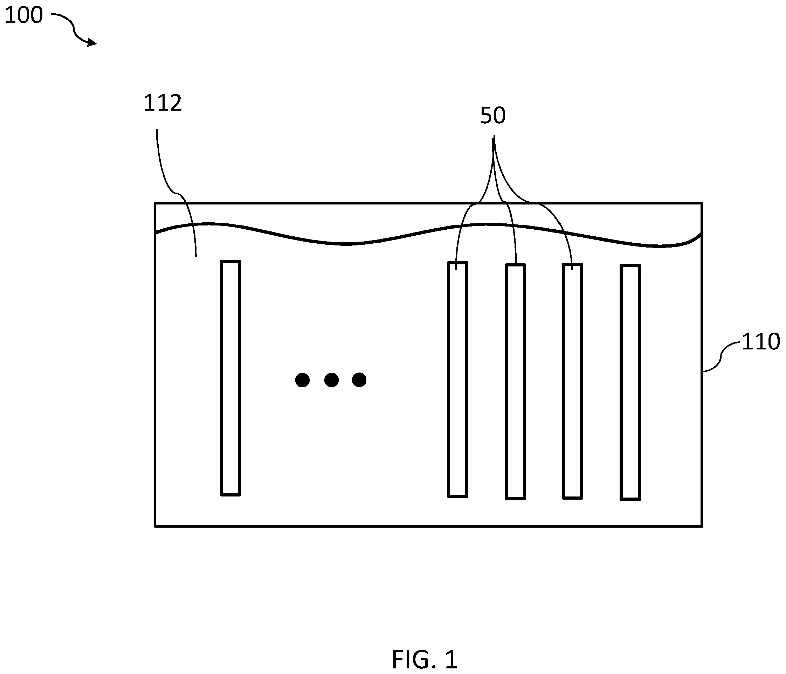

Figure 1 is a schematic diagram of an immersion cooling system 100. In the shown implementation, the cooling system 100, comprises an immersion case 110 configured to receive a heat-transfer liquid 112 having a top surface 113 and to receive one or more electronic assemblies 50 immersed in the heat-transfer liquid 112. Each electronic assembly 50 may include at least one electronic component to be cooled. An electronic assembly 50 is described in greater details herein after. The heat-transfer liquid 112 may be, for example and without limitations, a dielectric cooling liquid.

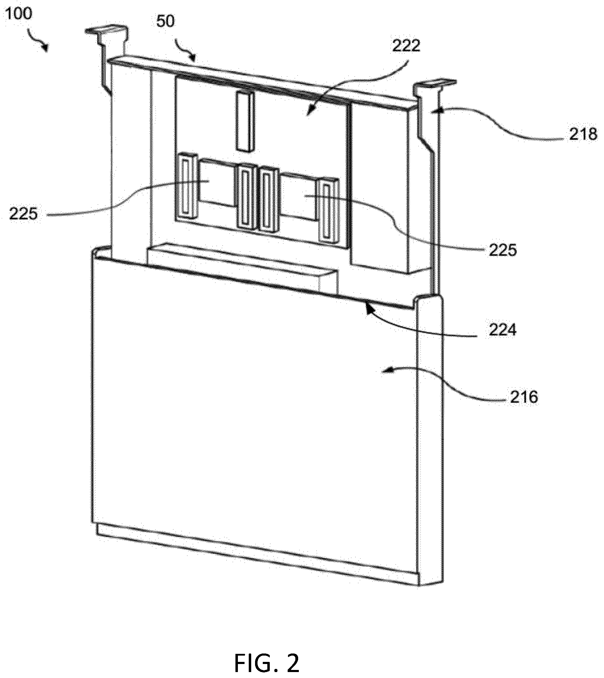

Figure 2 shows a perspective view of a cooling system 100 in accordance with a non-limiting implementation of the present technology. As shown, the cooling system 100 includes a detachable frame, or "board" 218 of an electronic assembly 50, and an immersion case 216. The board 218 holds electronic components 222 of the electronic assembly 50 and may be immersed in the immersion case 216. The electronic components 222 of the electronic assembly 50 include one or more processors 225, among other components. Although the immersion case 216, board 218, and electronic components 222 are shown as separate parts, it will be understood by one of ordinary skill in the art that, in some embodiments, two or more of these components could be combined. For example, the electronic components 222 could be fixed directly on the board 218 and/or the immersion case 216.

It is contemplated that the electronic assemblies 50 may generate a significant amount of heat. Consequently, the immersion cooling system 100 provides cooling to the electronic assemblies 50 to prevent them from being damaged. As used herein, the immersion cooling system 100 is a cooling system in which the immersion case 216 is open such that the electronic assembly 50 is in direct contact with the first heat-transfer liquid 112, which either flows over at least portions of the electronic assembly 50, or in which at least portions of the electronic assembly 50 are submerged in the immersion case 216. Further, the board 218 including the electronic components 222 may be submerged at least in part in the immersion case 216. In this implementation, the board 218 may be inserted into the immersion case 216 via an open-ended top side 224 of the immersion case 216. Figure 2 shows the board 218 in a partially inserted configuration into the immersion case 216. The open-ended top side 224 may remain at least partially open during operation of the electronic assembly 50, providing a non-sealed configuration for the immersion case 216. Such non-sealed configurations may be easier to manufacture and maintain than sealed configurations. Alternatively, the immersion case 216 may be closed and sealed once the board 218 in inserted, particularly if it is desired to operate the system 100 in a sealed configuration.

In some embodiments, the electronic assembly 50 may be a server that may be implemented as a conventional computer server. Each electronic assembly 50 may be implemented as a Dell^{™} PowerEdge^{™} Server running the Microsoft^{™} Windows Server^{™} operating system. Needless to say, each electronic assembly 50 may be implemented in any other suitable hardware, software, and/or firmware, or a combination thereof.

The electronic assembly 50 includes one or more electronic components 222 and the board 218 on which the one or more electronic assemblies 50 are mounted. The board 218 is at least in part immersed in the immersion case 216 that contains a volume of the heat-transfer liquid 112 for cooling of the electronic assembly 50.

In some embodiments, multiple electronic devices, similar to the electronic assembly 50, may be immersed in a single immersion case 216.

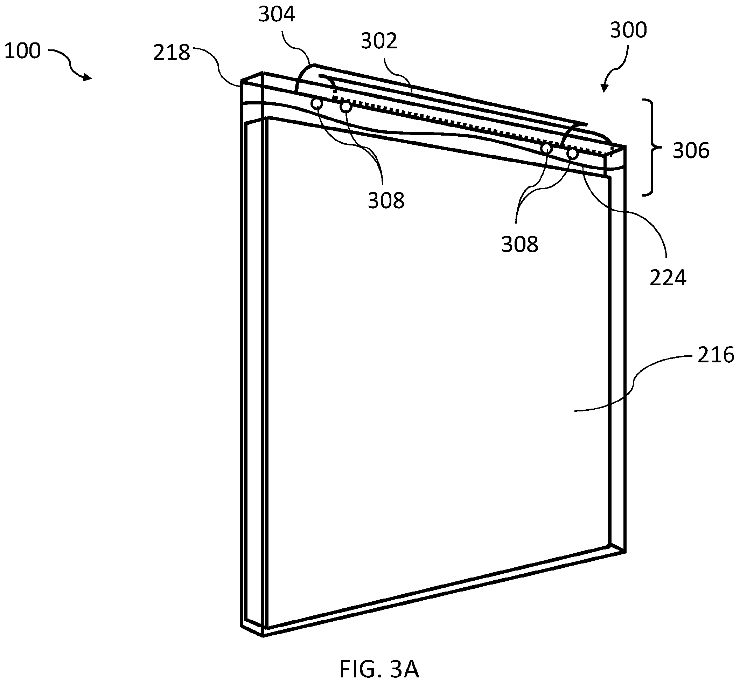

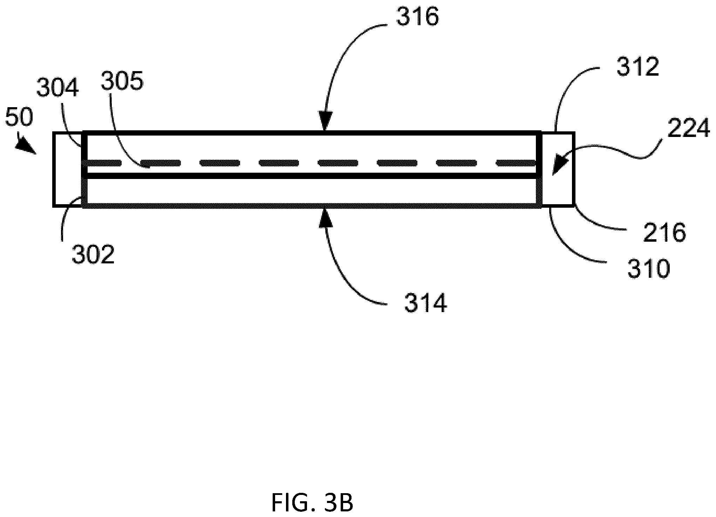

Figure 3A shows a perspective view of the cooling system 100 of Figure 2 in accordance with yet another non-limiting implementation of the present technology. Figure 3B shows a top elevation view of the cooling system 100 of Figure 3A. In Figure 3A, the board 218 is shown in a fully inserted configuration into the immersion case 216. In other words, the board 218 is completely immersed in the immersion case 216 that contains a volume of the heat-transfer liquid 112 for cooling of the electronic assembly 50.

In the embodiment of Figure 3A, the cooling system 100 is provided with a baffling assembly 300 for mitigating movement of the heat-transfer liquid 112 in the immersion case 216. Said movements may be for example caused by insertion and/or removal of the board 218 in the immersion case 216. In addition, the baffling assembly 300 may mitigate movements of the heat-transfer liquid 112 and their impact vibrations on a transport vehicle when the immersion case 216 is carried or transported. The baffling assembly 300 includes a first baffle element 302 and a second baffle element 304. The baffling assembly 300 is disposed proximate a top portion 306 of the immersion case 216. More specifically, the baffling assembly 300 is disposed at or near the open-ended top side 224 of the immersion case 216. The first baffle element 302 extends along a first edge 310 of the open-ended top side 224 of the immersion case 216 (see Figure 3B), and the second baffle element 304 extends along a second edge 312 of the open-ended top side 224 of the immersion case 216, the second edge 312 opposed to the first edge 310. The first baffle element 302 and the second baffle element 304 are fixedly attached to a first wall 314 and to a second wall 316 of the immersion case 216, respectively, the first wall 314 opposite to the second wall 316 (see Fig. 3B), via attachment points 308, using, for example and without limitation, screws, nails, anchors, or adhesive. Each of the first baffle element 302 and the second baffle element 304 has a plurality of attachment points 308. It is contemplated that the baffling assembly 300 could also be detachably connected to the immersion case 216 using a clamping or mounting system (not shown) provided with the baffling assembly 300 and/or the immersion case 216. In some non-limiting implementations, the baffling assembly 300 may be attached to the immersion case 216 using fasteners (e.g. clips) attached to the board 218 or to the immersion case 216 itself. For example, the board 218 may define openings to accommodate the fasteners. In some implementations, the first baffle element 302 and the second baffle element 304 extend from the board 218.

As shown, the first baffle element 302 and the second baffle element 304 have a curved planar shape, where a first convex surface of the first baffle element 302 and a second convex surface of the second baffle element 304 are facing at least partially away from the top surface 113 of the heat-transfer liquid 112 of the immersion case 216, the first convex surface being disposed opposite to the second convex surface. The first baffle element 302 and the second baffle element 304 are staggered with respect to each other in a direction orthogonal to the top surface 113, i.e. the second baffle element 304 is elevated with respect to the first baffle element 302. It is contemplated that the first baffle element 302 may be elevated with respect to the second baffle element 304 instead. In the embodiment shown, the second baffle element 304 at least partially overhangs the first baffle element 302. However, it is contemplated that the first baffle element 302 could at least partially overhang the second baffle element 304 instead. Moreover, the first baffle element 302 and the second baffle element 304 are disposed at least in part above the surface of the heat-transfer liquid 112. In some implementations, the first baffle element 302 and the second baffle element 304 have a curved planar shape defining holes.

In some embodiments, the baffling assembly 300 may have a single baffle element, or more than two baffle elements, as described hereinafter. The baffle elements may be disposed at different positions relative to the immersion case 216, for instance near, proximate, or just under the first edge 310 and/or the second edge 312. The baffle elements may have various shapes and orientations with respect to each other, as will be apparent to the person skilled in the art having the benefit of the present disclosure. For example, the first baffle element 302 and the second baffle element 304 may extend along an entirety, or along a portion thereof, of the edges of the immersion case 216.

As shown on Figure 3B, an overlap area 305 may be created by the overhang of the second baffle element 304 relative to the first baffle element 302. It is contemplated that the first baffle element 302 and the second baffle element 304 may be positioned such that there is no overlap area 305.

In some implementations, the baffling assembly 300 further include a third and a fourth baffle elements extending along a third and fourth edges of the immersion case 216 (i.e. extending along a width of the immersion case 216).

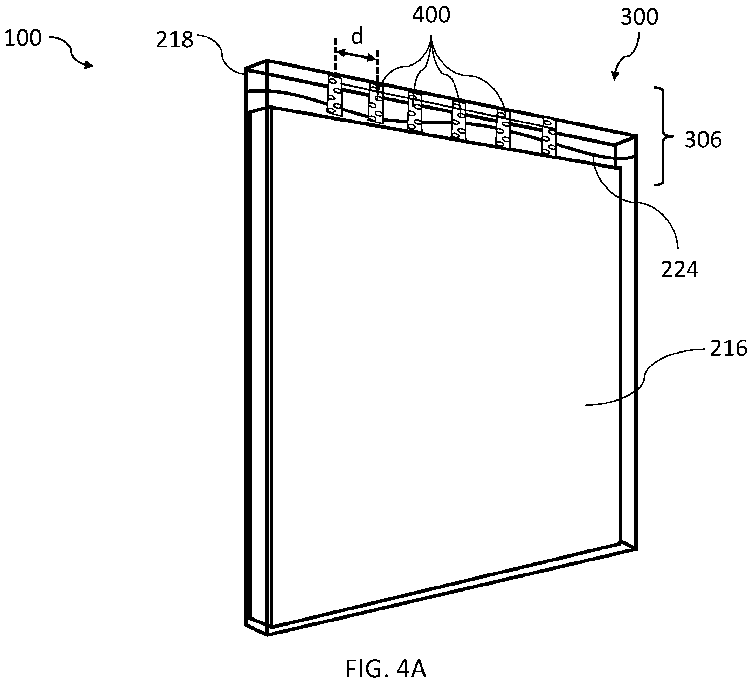

Figure 4A shows a perspective view of the cooling system 100 of Figure 2 in accordance with yet another non-limiting implementation of the present technology. In Figure 4A, similarly to Figure 3A, the board 218 is shown in a fully inserted configuration into the immersion case 216.

In the embodiment shown in Figure 4A, the baffling assembly 300 includes a plurality of baffle elements 400 disposed in a linear array parallel to the first edge 310 and to the second edge 312 of the immersion case 216 (see Figure 3B). At least some of the plurality of baffle elements 400 may be movable in a direction parallel to the first edge 310 and the second edge 312. Alternatively, a distance d between two consecutive baffle elements of the plurality of baffle elements 400 may be constant. In some non-limiting implementations, the baffling elements 400 may be attached to the immersion case 216 using fasteners (e.g. clips) attached to the board 218. For example, the board 218 may define openings to accommodate the fasteners.

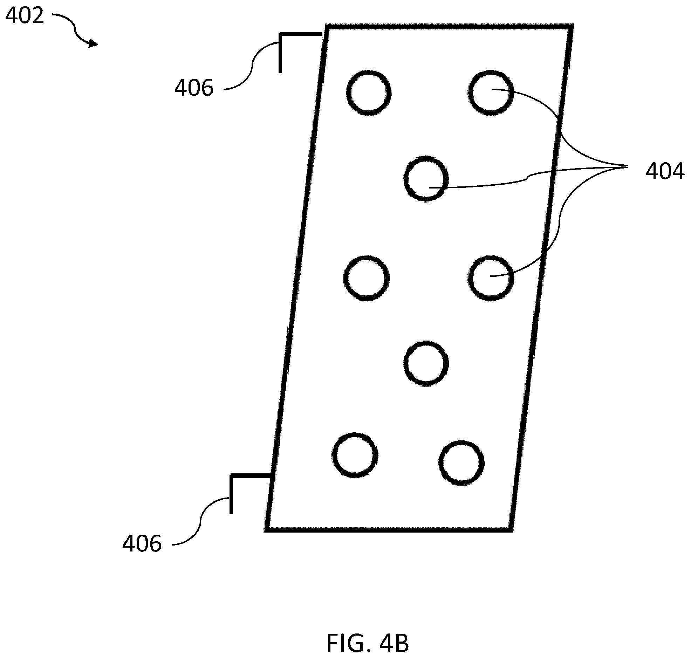

Figure 4B shows a front elevation view of one of the plurality of baffle elements 400 of Figure 4A in accordance with yet another non-limiting implementation of the present technology. Each of the baffle elements 400 as illustrated is a parallelogram-shaped plate member 402. The plate member 402 defines a plurality of holes 404 for letting at least some of the heat-transfer liquid 112 flow therethrough. It is contemplated that the plate member 402 could define no holes or a different number of holes 404. The baffle elements 400 include attachment points 406 that may include, for example and without limitation, screws, nails, anchors, or adhesive to secure the baffle elements to the immersion case 216.

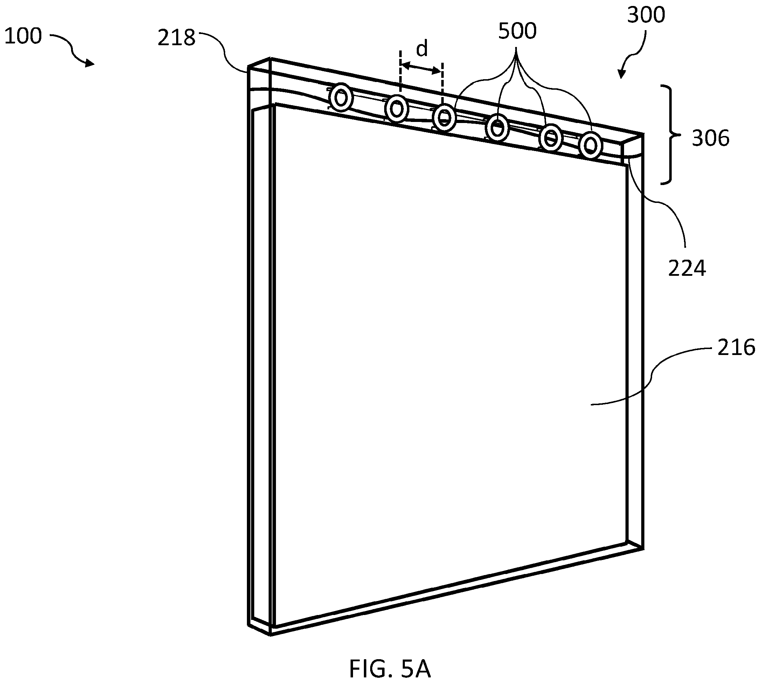

Figure 5A shows a perspective view of the cooling system 100 of Figure 2 in accordance with yet another non-limiting implementation of the present technology. In Figure 5A, similarly to Figures 3A and 4A, the board 218 is shown in a fully inserted configuration into the immersion case 216.

In the embodiment shown in Figure 5A, similarly to Figure 4A, the baffling assembly 300 includes a plurality of baffle elements 500 disposed in a linear array parallel to the first edge 310 and to the second edge 312 of the immersion case 216. At least some of the plurality of baffle elements 500 may be movable in a direction parallel to the first edge 310 and to the second edge 312. Alternatively, the distance d between two consecutive baffle elements of the plurality of baffle elements 500 may be constant.

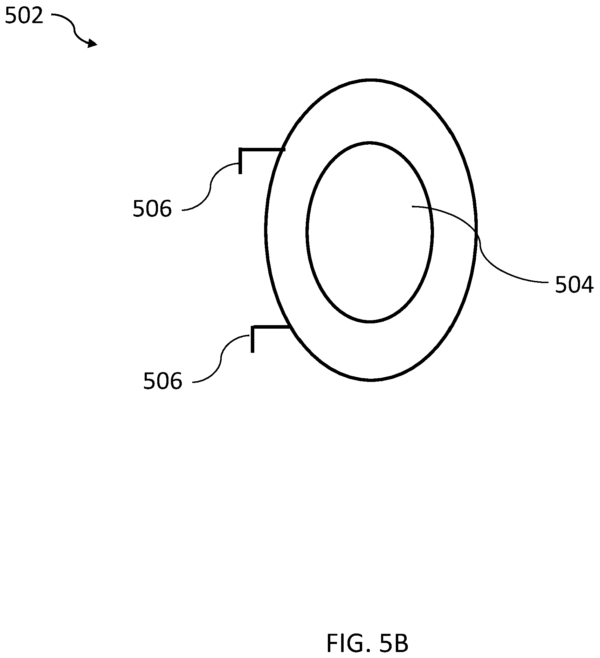

Figure 5B shows a front elevation view of one of the plurality of baffle elements 500 of Figure 5A in accordance with yet another non-limiting implementation of the present technology. Each of the baffle elements 500 as illustrated is an oval-shaped plate member 502. The plate member 502 defines at least one hole 504 for letting at least some of the heat-transfer liquid 112 flow therethrough. It is contemplated that the plate member 502 could define no holes or a different number of holes 504. The baffle elements 500 include attachment points 506 that may include, for example and without limitation, screws, nails, anchors, or adhesive to secure the baffle elements to the immersion case 216.

It is contemplated that other geometries of the baffling assembly 300 could be used. Each of the plurality of baffle elements 400 or 500 could have a shape other than a parallelogram or an oval, for example a triangular, hexagonal, or any other suitable polygonal shape. The plurality of baffle elements 400 or 500 could be disposed in a staggered configuration, with odd baffle elements staggered with respect to even baffle elements (or vice versa) in a direction substantially parallel to the open-ended top side 224 of the immersion case 216. The plurality of baffle elements 400 or 500 may be provided in a fixed configuration or may alternatively be movable. Finally, in some embodiments, the distance d between two consecutive baffle elements of the plurality of baffle elements 400 or 500 may be variable. In some non-limiting implementations, the baffling elements 500 may be attached to the immersion case 216 using fasteners (e.g. clips) attached to the board 218. For example, the board 218 may define openings to accommodate the fasteners.

While the above-described implementations have been described and shown with reference to particular steps performed in a particular order, it will be understood that these steps may be combined, sub-divided, or re-ordered without departing from the teachings of the present technology. At least some of the steps may be executed in parallel or in series. Accordingly, the order and grouping of the steps is not a limitation of the present technology.

It should be expressly understood that not all technical effects mentioned herein need to be enjoyed in each and every embodiment of the present technology.

Modifications and improvements to the above-described implementations of the present technology may become apparent to those skilled in the art. The foregoing description is intended to be exemplary rather than limiting. The scope of the present technology is therefore intended to be limited solely by the scope of the appended claims.

## Claims

1. A baffling assembly (300) for mitigating movement of a heat-transfer liquid (112) in an immersion case (216), the immersion case (216) being configured to contain the heat-transfer liquid in which an electronic device (50) is at least partially submerged, the baffling assembly comprising at least one baffle element (302/304) configured to be disposed proximate a top portion at an open-ended top side (224) of the immersion case, **characterized in that**:
the at least one baffle element comprises a first baffle element (302) and a second baffle element (304),
the first baffle element (302) extending laterally along a first edge (310) of the open-ended top side of the immersion case and the second baffle element (304) extending laterally along a second edge (312) of the open-ended top side that is opposite to the first edge (310) of the open-ended top side of the immersion case, and
the second baffle element (304) arranged to be elevated above the first baffle element (302) and at least partially overhang over the first baffle element (302) to maintain the top-side of the immersion case open-ended.

2. The baffling assembly of claim 1, wherein:
the first and second baffle elements have a curved planar shape,
a first convex surface of the first baffle element and a second convex surface of the second baffle element are facing at least partially away from a surface of the heat-transfer liquid side of the immersion case, and
the first convex surface is disposed opposite to the second convex surface.

3. The baffling assembly of claim 1 or 2, wherein the first and second baffle elements are staggered with respect to each other in a direction orthogonal to the first edge and the second edge.

4. The baffling assembly of anyone of claims 1 to 3, wherein the first and second baffle elements are disposed at least in part above the surface of the heat-transfer liquid.

5. The baffling assembly of anyone of claims 1 to 4, wherein the first and second baffle elements are movable in a direction parallel to the top portion of the immersion case.

6. The baffling assembly of anyone of claims 1 to 4, wherein a distance between the first and second baffle elements is constant.

7. The baffling assembly of claim 1, wherein the first and second baffle elements are parallelogram-shaped plate members.

8. The baffling assembly of claim 7, wherein each of the first and second baffle elements defines at least one hole for letting the heat-transfer liquid flow therethrough.

9. The baffling assembly of claim 7 or 8, wherein each of the first and second baffle elements is mechanically attached to a board of the electronic device.

10. The baffling assembly of claim 7 or 8, wherein each of the first and second baffle elements is mechanically attached to the electronic device.

11. An immersion case assembly for hosting an electronic device, the immersion case assembly comprising:
an immersion case configured to contain a heat-transfer liquid in which an electronic device is at least partially submerged; and
the baffling assembly of any one of claims 1 to 10.

## Patentansprüche

1. Ablenkeinheit (300) zur Bewegungsminderung einer Wärmeübertragungsflüssigkeit (112) in einem Tauchgehäuse (216), wobei das Tauchgehäuse (216) konfiguriert ist, die Wärmeübertragungsflüssigkeit zu enthalten, in der eine elektronische Vorrichtung (50) wenigstens teilweise eingetaucht ist, wobei die Ablenkeinheit wenigstens ein Ablenkelement (302/304) umfasst, das konfiguriert ist, nahe einem oberen Abschnitt an einer oben offenen Oberseite (224) des Tauchgehäuses angeordnet zu sein, **dadurch gekennzeichnet, dass**:
das wenigstens eine Ablenkelement ein erstes Ablenkelement (302) und ein zweites Ablenkelement (304) umfasst,
wobei sich das erste Ablenkelement (302) seitlich entlang einer ersten Kante (310) der oben offenen Oberseite des Tauchgehäuses erstreckt und sich das zweite Ablenkelement (304) seitlich entlang einer zweiten Kante (312) der oben offenen Oberseite erstreckt, die der ersten Kante (310) der oben offenen Oberseite des Tauchgehäuses gegenüberliegt, und
das zweite Ablenkelement (304) so angeordnet ist, dass es über dem ersten Ablenkelement (302) erhöht ist und wenigstens teilweise über das erste Ablenkelement (302) überhängt, um die Oberseite des Tauchgehäuses offen zu halten.

2. Ablenkeinheit nach Anspruch 1, wobei:
das erste und das zweite Ablenkelement eine gekrümmte ebene Form aufweisen,
eine erste konvexe Oberfläche des ersten Ablenkelements und eine zweite konvexe Oberfläche des zweiten Ablenkelements wenigstens teilweise von einer Oberfläche der Wärmeübertragungsflüssigkeitsseite des Tauchgehäuses wegweisen, und
die erste konvexe Oberfläche der zweiten konvexen Oberfläche gegenüberliegt.

3. Ablenkeinheit nach Anspruch 1 oder 2, wobei das erste und das zweite Ablenkelement in einer Richtung orthogonal zur ersten Kante und zur zweiten Kante zueinander versetzt sind.

4. Ablenkeinheit nach einem der Ansprüche 1 bis 3, wobei das erste und das zweite Ablenkelement wenigstens teilweise über der Oberfläche der Wärmeübertragungsflüssigkeit angeordnet sind.

5. Ablenkeinheit nach einem der Ansprüche 1 bis 4, wobei das erste und das zweite Ablenkelement in einer Richtung parallel zum oberen Abschnitt des Tauchgehäuses beweglich sind.

6. Ablenkeinheit nach einem der Ansprüche 1 bis 4, wobei ein Abstand zwischen dem ersten und dem zweiten Ablenkelement konstant ist.

7. Ablenkeinheit nach Anspruch 1, wobei das erste und das zweite Ablenkelement parallelogrammförmige Plattenelemente sind.

8. Ablenkeinheit nach Anspruch 7, wobei jedes des ersten und des zweiten Ablenkelements wenigstens ein Loch zum Hindurchfließen der Wärmeübertragungsflüssigkeit definiert.

9. Ablenkeinheit nach Anspruch 7 oder 8, wobei jedes des ersten und des zweiten Ablenkelements mechanisch an einer Platine der elektronischen Vorrichtung befestigt ist.

10. Ablenkeinheit nach Anspruch 7 oder 8, wobei jedes des ersten und des zweiten Ablenkelements mechanisch an der elektronischen Vorrichtung befestigt ist.

11. Tauchgehäusebaugruppe zum Aufnehmen einer elektronischen Vorrichtung, wobei die Tauchgehäusebaugruppe umfasst:
ein Tauchgehäuse, das konfiguriert ist, eine Wärmeübertragungsflüssigkeit zu enthalten, in der eine elektronische Vorrichtung wenigstens teilweise eingetaucht ist; und
die Ablenkeinheit nach einem der Ansprüche 1 bis 10.

## Revendications

1. Ensemble déflecteur (300) pour atténuer le mouvement d'un liquide de transfert de chaleur (112) dans un boîtier d'immersion (216), le boîtier d'immersion (216) étant configuré pour contenir le liquide de transfert de chaleur dans lequel un dispositif électronique (50) est au moins partiellement immergé, l'ensemble déflecteur comprenant au moins un élément déflecteur (302/304) configuré pour être disposé à proximité d'un côté supérieur ouvert (224) du boîtier d'immersion, **caractérisé en ce que** :
l'au moins un élément déflecteur comprend un premier élément déflecteur (302) et un second élément déflecteur (304),
le premier élément déflecteur (302) se prolongeant latéralement le long d'un premier bord (310) du côté supérieur ouvert du boîtier d'immersion et le second élément déflecteur (304) se prolongeant latéralement le long d'un second bord (312) du côté supérieur ouvert qui est opposé au premier bord (310) du côté supérieur ouvert du boîtier d'immersion, et
le second élément déflecteur (304) étant agencé pour être élevé au-dessus du premier élément déflecteur (302) et surplomber au moins partiellement le premier élément déflecteur (302) pour maintenir le côté supérieur du boîtier d'immersion ouvert.

2. Ensemble déflecteur selon la revendication 1, dans lequel :
les premier et second éléments déflecteurs ont une forme plane incurvée,
une première surface convexe du premier élément déflecteur et une seconde surface convexe du second élément déflecteur sont tournées au moins partiellement à l'opposé d'une surface du côté liquide de transfert de chaleur du boîtier d'immersion, et
la première surface convexe est disposée à l'opposé de la seconde surface convexe.

3. Ensemble déflecteur selon la revendication 1 ou 2, dans lequel les premier et second éléments déflecteurs sont décalés l'un par rapport à l'autre dans une direction orthogonale au premier bord et au second bord.

4. Ensemble déflecteur selon l'une quelconque des revendications 1 à 3, dans lequel les premier et second éléments déflecteurs sont disposés au moins en partie au-dessus de la surface du liquide de transfert de chaleur.

5. Ensemble déflecteur selon l'une quelconque des revendications 1 à 4, dans lequel les premier et second éléments déflecteurs sont mobiles dans une direction parallèle à la partie supérieure du boîtier d'immersion.

6. Ensemble déflecteur selon l'une quelconque des revendications 1 à 4, dans lequel une distance entre les premier et second éléments déflecteurs est constante.

7. Ensemble déflecteur selon la revendication 1, dans lequel les premier et second éléments déflecteurs sont des composants de plaque en forme de parallélogramme.

8. Ensemble déflecteur selon la revendication 7, dans lequel chacun des premier et second éléments déflecteurs définit au moins un trou pour laisser le liquide de transfert de chaleur s'écouler à travers celui-ci.

9. Ensemble déflecteur selon la revendication 7 ou 8, dans lequel chacun des premier et second éléments déflecteurs est fixé mécaniquement à une carte du dispositif électronique.

10. Ensemble déflecteur selon la revendication 7 ou 8, dans lequel chacun des premier et second éléments déflecteurs est fixé mécaniquement au dispositif électronique.

11. Ensemble de boîtier d'immersion pour héberger un dispositif électronique, l'ensemble de boîtier d'immersion comprenant :
un boîtier d'immersion configuré pour contenir un liquide de transfert de chaleur dans lequel un dispositif électronique est au moins partiellement immergé ; et
l'ensemble déflecteur selon l'une quelconque des revendications 1 à 10.
